# EUROPÄISCHE PATENTSCHRIFT

(11) **EP 0 651 433 B1**
(45) Veröffentlichungstag und Bekanntmachung des Hinweises auf die Patenterteilung: **12.07.2000**
(21) Anmeldenummer: 94117264.5
(22) Anmeldetag: 02.11.1994
(51) Int. Cl.: H01L 21/285, H01L 21/321

(54) **Verfahren zur Herstellung eines Kontaktlochs zu einem dotierten Bereich**
Method of making a contact hole to a doped region
Procédé de fabrication d'un trou de contact sur une région dopée

(30) Priorität: 02.11.1993 DE 4337355
(43) Veröffentlichungstag der Anmeldung: 03.05.1995
(73) Patentinhaber: SIEMENS AKTIENGESELLSCHAFT, 80333 München (DE)
(72) Erfinder: Melzner, Hanno, Dipl.-Phys., D-85655 Grosshelfendorf (DE); Joswig, Hellmut, Dr., Burlington, VT (US); Muller, Wolfgang, Dr., Bolton Valley, VT 05477 (US)

(56) Entgegenhaltungen:
- EP-A- 0 543 158
- EP-A- 0 567 815
- US-A- 4 573 257
- IEEE TRANSACTIONS ON ELECTRON DEVICES, Bd.35, Nr.10, Oktober 1987, NEW YORK US Seiten 1601 - 1608 Y.YAMAMOTO ET AL. 'SDX:A NOVEL SELF-ALIGNED TECHNIQUE AND ITS APPLICATION TO HIGH-SPEED BIPOLAR LSI'S'

## Beschreibung

Die Erfindung betrifft ein Verfahren zur Herstellung eines Kontaktlochs zu einem dotierten Bereich in einem Substrat.

In der Mikroelektronik werden zur Platzeinsparung und zur Erhöhung der Prozeßsicherheit häufig sog. selbstjustierte Kontakte eingesetzt. Ein selbstjustierter Kontakt ist dadurch ausgezeichnet, daß ein elektrischer Kontakt nur zu einem bestimmten leitenden Gebiet der Schaltung, z.B. zum Sourcegebiet eines Transistors hergestellt wird, auch wenn die zur Erzeugung des Kontakts üblicherweise verwendete Öffnung in einer Maskenschicht, z.B. Fotolack, größer ist und über andere leitende Gebiete, z.B. das Transistorgate, überlappt. Dies bietet den Vorteil, daß unabhängig von der genauen Größe und Lage der Öffnung in der Maskenschicht kein Kurzschluß zu nicht kontaktierenden Gebieten hergestellt wird. Dies erhöht erstens offenbar die Prozeßsicherheit. Zweitens kann im Design der Schaltung auf anderenfalls vorzusehende Sicherheitsabstände zwischen Kontakt und nicht zu kontaktierenden leitenden Gebieten verzichtet werden und so eine Platzersparnis erreicht werden.

Besonders wichtig ist dies in Speicherzellen, z. B. DRAMs, da hier die üblicherweise erforderlichen Sicherheitsabstände einen signifikanten Anteil des Zellrasters ausmachen und andererseits die Chipfläche bei derartigen Produkten einen maßgeblichen Wirschaftlichkeitsfaktor darstellt. In DRAMs werden selbstjustierte Kontakte vorzugsweise beim Bitleitungskontakt, d. h. dem Anschluß der Bitleitung an ein S/D-Gebiet des MOS-Transistors einer Speicherzelle eingesetzt. Bisher sind folgende Konzepte zur Herstellung selbstjustierter Kontakte bekannt, wobei als erster Schritt immer die Gates mittels einer gemeinsam mit den Gates strukturierten dielektrischen Schicht nach oben und durch sogenannte Spacer zur Seite hin isoliert werden:
- Einbau einer dünnen Siliziumnitridschicht vor Abscheidung eines dicken isolierenden und planarisierenden Oxids. Der Kontakt wird mit einer Flußsäurelösung naß geätzt, wobei die Nitridschicht als Ätzstop wirkt. Anschließend wird die dünne Nitridschicht geätzt, wobei die Ätzung so kurz gehalten werden kann, daß die Einkapselung der Gates erhalten bleibt. Ferner wird auch das außerhalb der aktiven Gebiete vorhandene Feldoxid nicht übermäßig abgetragen, so daß der Kontakt auch über Feldoxidkanten selbstjustiert hergestellt werden kann. Ein Nachteil dieses Verfahrens ist die isotrope Naßätzung des Kontakts, die einen Einsatz bei kleineren Strukturgrößen nicht mehr gestattet.
- In diesem Fall kann als Ätzstopschicht eine Polysiliziumschicht eingesetzt werden, da anisotrope trockene Oxidätzungen bekannt sind, die Polysilizium wenig angreifen. Allerdings muß diese Polysiliziumschicht während oder nach der Herstellung der Kontakte entfernt, in ein Dielektrikum umgewandelt oder isoliert werden, da eine durchgehende Polysiliziumschicht zwischen den Kontakten einen Leckstrompfad bieten würde. Verschiedene Verfahren zur Umwandlung oder Isolation der Polysiliziumschicht sind bekannt. Ein Nachteil aller Verfahren ist die umständliche und fehleranfällige Prozeßführung.

Ein weiterer Nachteil aller Verfahren ist die Tatsache, daß Kontakte zu leitenden Gebieten im Substrat mit einer anderen Prozeßführung und damit mit einer anderen Maskenebene als solche zum Gate hergestellt werden müssen. Dies gestaltet die Prozeßführung in der folgenden Metallisierungsebene je nach Prozeßführung umständlich und bringt zusätzliche Risiken mit sich (Lack-Kontamination in bereits geöffneten Kontaktlöchern, Justagefehler der beiden Kontakttypen gegeneinander).

Als Beispiel eines herkömmlichen Verfahrens kann das, im IEEE Transactions on Electron Devices, vol.35, ho. 10, October 1988, Seiten 1601-1608, offenbarte Verfahren zitiert werden.

Aufgabe der Erfindung ist es, ein verbessertes Verfahren zur Herstellung eines Kontaktlochs zu einem dotierten Bereich eines Leitfähigkeitstyps bei einem Wafer mit dotierten Gebieten vom ersten und eines zweiten Leifähigkeitstyps anzugeben.

Diese Aufgabe wird durch ein Verfahren mit den Merkmalen des Patentanspruchs 1 gelöst. Weitere Ausgestaltungen der Erfindung gehen aus den Unteransprüchen hervor.

In dem erfindungsgemäßen Verfahren wird ausgenutzt, daß undotiertes Silizium selektiv zu dotiertem Silizium entfernt werden kann. Die undotierte Siliziumschicht, die z.B. polykristallin ist, wird durch eine Ionenimplantation unter Verwendung einer Maske selektiv im Bereich des späteren Kontaktes dotiert. Eine Diffusionsbarriereschicht, die mindestens den ersten dotierten Bereich freiläßt und einen zweiten dotierten Bereich vom entgegengesetzeten Leifähigkeitstyp abdeckt, ist unter der Siliziumschicht angeordnet und verhindert eine unerwünschte Diffusion von Dotierstoffen an anderen Stellen, bspw. aus entgegengesetzt dotierten Substratbereichen , in die Siliziumschicht insbesondere bei einer nachfolgenden Temperung. Anschließend wird der undotierte Teil der Siliziumschicht selektiv zu dem dotierten Gebiet entfernt. Es wird ganzflächig eine Isolationsschicht erzeugt, in der das Kontaktloch durch anisotropes Ätzen selektiv zu dem dotierten Gebiet in der Siliziumschicht geöffnet wird. Das dotierte Gebiet in der Siliziumschicht wirkt dabei als Ätzstop und wird nicht mehr entfernt.

Es ist vorteilhaft, die Siliziumschicht so zu erzeugen, daß sie mindestens in dem dotierten Gebiet aus Polysilizium besteht, da Siliziumoxid, das die Isolationsschicht in der Regel im wesentlichen enthält, mit hoher Selektivität zu Polysilizium ätzbar ist.

Die im Stand der Technik erforderliche, problematische nachträgliche Aufoxidation der Siliziumschicht entfällt, da die undotierten Teile der Siliziumschicht außerhalb des Kontaktlochs entfernt werden Die Erfindung wird im folgenden anhand eines Ausführungs

beispiels und der Figuren näher erläutert.

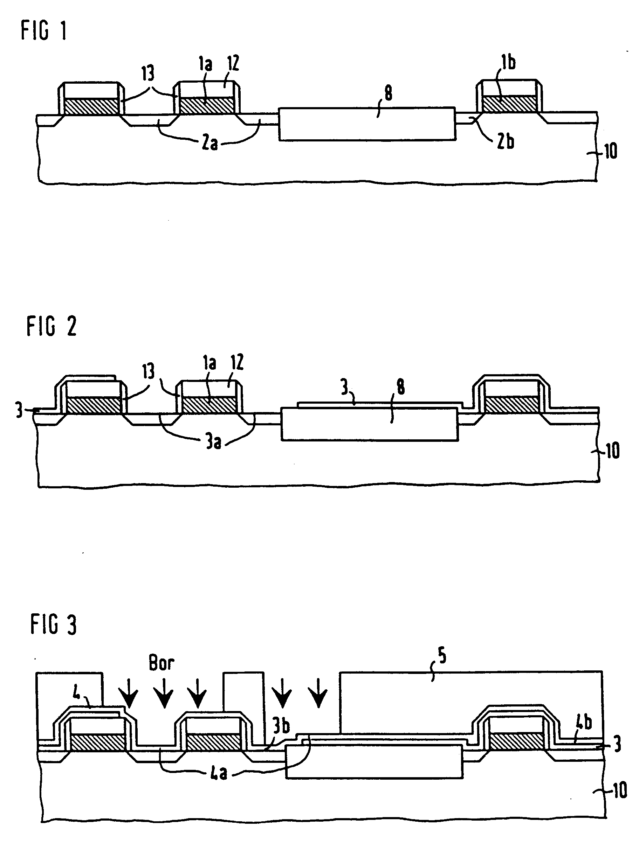

- Die Figuren 1-5: zeigen einen Querschnitt durch ein Halbleitersubstrat mit einem MOS-Transistor, an dem die Verfahrensschritte beispielhaft erläutert werden.

Figur 1: In bzw. auf einem Si-Halbleitersubstrat 10 befindet sich ein MOS-Transistor mit einem Gate 1a und zwei S/D- Gebieten 2a als p-dotierten Bereichen im Substrat. Durch ein Isolationsgebiet 8, bspw. ein Feldoxid , ist ein weiterer MOS-Transistor mit Gate 1b und n-dotierten Bereichen 2b davon getrennt. Wie oben beschrieben, werden die Gates 1 nach oben 12 und zur Seite 13 hin isoliert. Die Source- und Draingebiete 2a, 2b werden wie üblich dotiert. Der Prozeß ist besonders vorteilhaft für selbstjustierte Kontakte auf p-dotierten Gebieten 2a einsetzbar, d. h. die Dotierung erfolgt hier üblicherweise mit Bor.

Figur 2: Sodann wird eine dünne Barriereschicht 3, etwa Siliziumnitrid, abgeschieden. An Stellen 3a, wo später selbstjustierte Kontakte erzeugt werden sollen, wird diese Schicht mittels eines Ätzprozesses unter Einsatz einer Fotomaske geöffnet. Die Ätzung der Barriereschicht kann kurz gehalten werden, so daß die Einkapselung der Gates 12, 13 erhalten bleibt.

Figur 3: Anschließend wird eine Polysiliziumschicht 4 abgeschieden. Mit einer weiteren Fotomaske 5 wird die Polysiliziumschicht an denjenigen Stellen 4a mit einem geeigneten Dotierstoff, hier insbesondere mit Bor implantiert, an denen ein selbstjustierter Kontakt vorgesehen ist. Der borimplantierte Bereich 4a ist vorzugsweise etwas größer als das spätere Kontaktloch zu bilden. Die Implantation wird mit so niedriger Energie durchgeführt, daß praktisch die gesamte Dosis in der Polysiliziumschicht 4 deponiert wird. Durch eine Temperung wird das Bor in der Polysiliziumschicht 4 verteilt und elektrisch aktiviert. Die Bor-Dotierung wird in Abhängigkeit von dem später erfolgenden Ätzprozeß und dessen Selektivität von undotiertem zu dotiertem Polysilizium gewählt und beträgt i.a. >10¹⁹ cm⁻³, vorzugsweise etwa 10²⁰ cm⁻³. Die unterliegende Barriereschicht 3 verhindert, daß an Stellen ohne selbstjustierten Kontakt, insbesondere an n-dotierten Stellen 4b wie beispielsweise Dotierstoff in die Polysiliziumschicht 4 eindiffundiert.

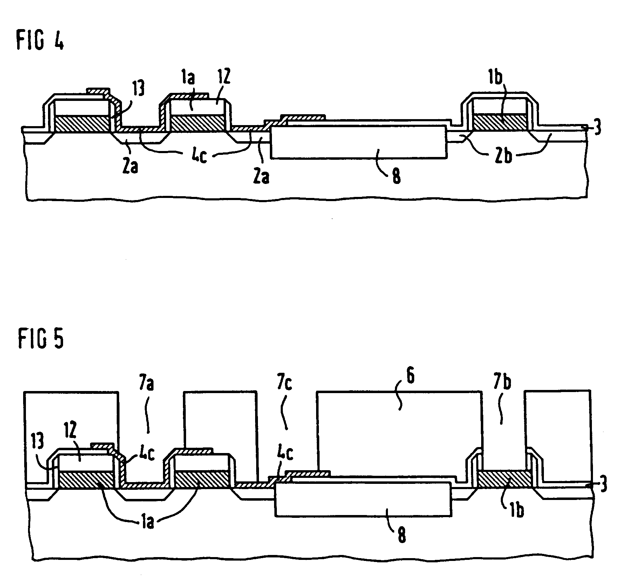

Figur 4: Beispielsweise mittels einer KOH-Lösung kann nach Entfernen der Fotomaske 5 undotiertes Polysilizium selektiv zu dotiertem geätzt werden. Durch eine solche Ätzung wird das Polysilizium überall dort entfernt, wo es kein oder nur sehr wenig Bor enthält. Je nach Implantationsbedingungen wird der vertikale Teil der Polysiliziumschicht möglicherweise weniger hoch dotiert, so daß er durch die Ätzung entfernt wird. Dies ist nicht problematisch, da bei der späteren Herstellung der Kontakte eine anisotrope Ätzung eingesetzt wird und somit ein Ätzstop an der vertikalen Flanke des Gates nicht erforderlich ist. Die unterliegende Barriereschicht 3 verhindert einen Angriff des Substrats 2a, 2b bei der KOH-Ätzung an Stellen ohne selbstjustierten Kontakt, insbesondere in n-dotierten Bereichen 2b. Die Öffnungen in dieser Schicht über p-dotierten Gebieten 3a können je nach Erfordernissen des Designs vollständig vom implantierten Gebiet 4a überdeckt werden oder auch dieses überlappen. Auch an diesen Überlappungsstellen 3b kommt es nicht zu einer Anätzung des Substrats, da hier die Polysiliziumschicht 4 durch ausdiffundiertes Bor aus dem Substrat 2a dotiert und damit ätzresistent wird. An der Stelle des späteren selbstjustierten Kontaktes, d. h. auf dem dotierten Bereich sind nun dotierte Polysiliziumpads 4c hergestellt, die durch die Öffnungen 3a in der Barriereschicht in elektrischem Kontakt zum dotierten Bereich 2a stehen.

Figur 5: Nun kann optional die Barriereschicht 3 durch eine ganzflächige kurze Ätzung an den freiliegenden Stellen entfernt werden. In jedem Fall wird anschließend ein dickes Dielektrikum 6, in der Regel ein Siliziumoxid, zur Isolation und Planarisierung aufgebracht. In dieses werden mit einer Kontaktlochmaske und einer anisotropen trockenen Oxidätzung sowohl die Kontaktlöcher zum Substrat wie auch zum Gate hergestellt. Unter allen selbstjustiert vorgesehenen Kontakten 7a befindet sich je ein von allen anderen Pads isoliertes Polysiliziumpad 4c ("Boron implanted Polysilicon Pad", BIPP), das wie beschrieben so groß hergestellt wurde, daß die Kontaktlochmaske selbst im Fall ungünstigster Dejustage nicht über das Pad überlappt. Sollte die Kontaktlochmaske an einer solchen Stelle über ein Gate 1a überlappen, so stoppt die Ätzung auf diesem Pad 4c, so daß die dielektrische Gateeinkapselung 12, 13 erhalten bleibt und kein Kurzschluß zum Gate 1a hergestellt wird. An Stellen, wo ein Kontakt 7b zum Gate 1b vorgesehen ist, befindet sich kein Pad. Hier öffnet die Kontaktlochätzung das Gate 1b, so daß ein elektrischer Kontakt hergestellt werden kann. Mit derselben Prozeßfolge können auch Kontakte 7c hergestellt werden, die teilweise auf Feldoxid 8 überlappen oder sogar vollständig über Feldoxid angeordnet sind. Auch alle nicht selbstjustierten Kontakte zum Substrat, insbesondere solche auf n-dotierte Gebiete 2b, können gleichzeitig hergestellt werden. In diesem Fall befindet sich kein Pad unter dem Kontakt. Der weitere Metallisierungsprozeß wird wie üblich (mit oder ohne Auffüllung der Kontaktlöcher) durchgeführt.

Besonders vorteilhaft läßt sich dieses Verfahren in einer Speicherzelle einsetzen, die einen sog. BOSS-Strap besitzt (Boron out-diffused surface strap), wie in der EP-A 543 158 beschrieben. Dieser Strap verbindet in einer DRAM-Speicherzelle das Draingebiet des Transistors mit einer im Innern des Kondensatorgrabens angeordneten Polysiliziumfüllung. Bei dem Herstellverfahren für einen solchen BOSS-Strap sind die meisten oben geschilderten Schichtabscheidungen, Fototechniken und sonstige Prozeßschritte bereits implementiert. Zur Durchführung des erfindungsgemäßen Verfahrens werden lediglich folgende Prozeßschritte hinzugefügt:
- eine Fototechnik zur Definition der BIPP-Pads
- die Implantation und
- der Lackstripprozeß.

Diese Prozeßschritte werden in dem in der EP-A 543 158 beschriebenen Verfahren sinnvollerweise nach der Abscheidung des Polysiliziums und vor der Temperung eingefügt. Für weitere Einzelheiten wird auf dem gesamten Inhalt der genannten Anmeldung verwiesen.

Ein besonderer Vorteil der Kopplung der Erfindung mit dem BOSS-Prozeß besteht darin, daß eine Beeinträchtigung oder Veränderung der Grundprozeßperformance (Transistordaten, Leckströme etc.) so gut wie ausgeschlossen ist, da kaum neue Prozeßschritte hinzugefügt werden. Insbesondere bleibt die Temperaturbelastung unverändert, da die zur Aktivierung des implantierten Bors erforderliche Temperung bereits im BOSS-Prozeß enthalten ist. Bei Verwendung des erfindungsgemäßen Prozesses ist daher keine erneute Optimierung des Grundprozesses erforderlich.

Auch im Design läßt sich das erfindungsgemäße Verfahren einfach und sinnvoll mit dem BOSS-Prozeß verbinden. Der BOSS-Strap ist selbstjustiert zu den Gates, da nur im Bereich zwischen den Gates das Polysilizium in Kontakt zum bordotierten Substrat (und zur Grabenfüllung) steht und also nur hier durch Ausdiffusion ätzresistent wird. Es ist somit sehr leicht möglich, ein ausreichend großes BIPP-Pad in die Zelle zu integrieren. Die einzige Randbedingung ist, daß das BIPP-Pad nicht über die kontaktabgewandte Gatekante überlappen darf. Wie man leicht abschätzen kann, ist diese Randbedingung ohne weiteres zu erfüllen, und zwar besonders dann, wenn wie allgemein üblich der Zelltransistor zur Verringerung von Unterschwellenspannungs-Leckströmen deutlich länger ist als die minimale Entwurfsregel des Designs. In diesem Fall ist das Gate im in Frage stehenden Bereich relativ breit, was einen besonders großen Spielraum zur konkreten Gestaltung des borimplantierten Polizilimpads eröffnet. Im einzelnen sind im Design die folgenden Anpassungen durchzuführen:
- Optional: Herausnehmen des Sicherheitsabstands zwischen Kontakt und Gate, Anpassen aller Ebenen an das verringerte Wortleitungsraster. Diese Maßnahme ist nicht erforderlich, wenn nur eine Erhöhung der Prozeßsicherheit ohne Platzersparnis angestrebt wird.
- Änderung der Maske zur Strukturierung der dünnen dielektrischen Schicht unter dem Polysilizium: zusätzliche Öffnung im Bereich des Bitleitungskontakts
- Einbau des borimplantierten Polysiliziumpads
- Optional: Vergrößerung des Kontaktlochs zur Erhöhung der Prozeßsicherheit
- Optional: Einsatz des erfindungsgemäßen Kontakts auch bei sonstigen p-dotierten Gebieten, z.B. in Rasterschaltungen zur weiteren Platzersparnis.

## Patentansprüche

1. Verfahren zur Herstellung eines Kontaktloches zu einem ersten dotierten Bereich eines ersten Leitfähigkeitstyp bei einer Halbleiterscheibe mit dotierten Bereichen des ersten und eines zweiten Leitfähigkeitstyps,
- bei dem zunächst der erste dotierte Bereich (2a) in dem Substrat (10) so hergestellt wird, daß er mindestens an der Oberfläche des Substrats (1) von Isolationsbereichen (12, 13) begrenzt ist,
- bei dem dann eine als Diffusions- bzw. Ätzbarriere vorgesehene Barriereschicht (3) erzeugt wird, die mindestens den ersten dotierten Bereich (2a) freiläßt und einen zweiten dotierten Bereich (2b) eines zweiten Leitfähigkeitstyps abdeckt,
- bei dem ganzflächig eine undotierte Siliziumschicht (4) abgeschieden wird,
- bei dem in der Siliziumschicht (4) selektiv ein dotiertes Gebiet durch Implantation oder zusätzlich durch Ausdiffusion aus dem ersten dotierten Bereich (2a) erzeugt wird, das den Bereich für das spätere Kontaktloch überlappt,
- bei dem eine Temperung zur Verteilung und Aktivierung des Dotierstoffs in dem dotierten Gebiet der Siliziumschicht (4) vorgenommen wird, wobei an den Stellen, an denen die Barriereschicht (3) den zweiten dotierten Bereich (2b) abdeckt, eine Ausdiffusion aus dem zweiten dotierten Bereich in die undotierte Siliziumschicht (4) verhindert wird,
- bei dem undotierte Teile der Siliziumschicht (4) selektiv zu dem dotierten Gebiet entfernt werden,
- bei dem ganzflächig eine Isolationsschicht (6) erzeugt wird,
- bei dem das Kontaktloch (7a) durch anisotropes Ätzen selektiv zu dem dotierten Gebiet (4c) der Siliziumschicht in der Isolationsschicht (6) geöffnet wird.

2. Verfahren nach Anspruch 1, bei dem das Substrat (10) aus einkristallinem Silizium besteht.

3. Verfahren nach Anspruch 1 oder 2, bei dem die Siliziumschicht (4) aus Polysilizium hergestellt wird.

4. Verfahren nach einem der Ansprüche 1 bis 3, bei dem die undotierten Teile der Siliziumschicht (4) durch naßchemisches Ätzen entfernt werden.

5. Verfahren nach einem der Ansprüche 1 bis 4, bei dem die Barriereschicht (3) aus Siliziumnitrid hergestellt wird.

6. Verfahren nach einem der Ansprüche 1 bis 5, bei dem vor Aufbringen der Isolationsschicht (6) die freiliegenden Teile der Barriereschicht (3) entfernt werden.

7. Verfahren nach einem der Ansprüche 1 bis 6, bei dem das dotierte Gebiet (4c) der Siliziumschicht (4) p-dotiert wird und bei dem die undotierten Teile der Siliziumschicht (4) durch naßchemische Ätzung mit Kalium-Hydroxid-Lösung entfernt werden.

8. Verfahren nach Anspruch 7, bei dem in dem dotierten Gebiet (4c) der Siliziumschicht (4) eine Borkonzentration zwischen 10¹⁹ cm⁻³ und 10²¹ cm⁻³ eingestellt wird.

9. Verfahren nach einem der Ansprüche 1 bis 8,
- bei dem der dotierte Bereich (2a) im Substrat (10) ein Source-Drain-Gebiet eines MOS-Transistors ist,
- bei dem die Isolationsbereiche isolierende Flankenbedeckungen (13) und isolierende Deckschichten (12) der Gateelektrode (1) des MOS-Transistor umfassen.

10. Verfahren nach Anspruch 9,
- bei dem gleichzeitig mit Öffnung des Kontaktloches (7a, 7c) zu dem dotierten Bereich (2a) ein weiteres Kontaktloch (7b) zur Gateelektrode (10) geöffnet wird.

11. Verfahren nach einem der Ansprüche 9 bis 10, bei dem der MOS-Transistor (1, 2) ein Auswahltransistor einer Speicherzelle ist, welche einen Speicherkondensator umfaßt, wobei eine Elektrode des Speicherkondensators mit einem weiteren dotierten Gebiet des MOS-Transistors über eine dotierte Polysiliziumstruktur verbunden ist.

## Claims

1. Method for the fabrication of a contact hole to a first doped region of a first conductivity type in a semiconductor wafer having doped regions of the first and of a second conductivity type,
- in which first of all the first doped region (2a) is fabricated in the substrate (10) in such a way that it is bounded by insulation regions (12, 13) at least on the surface of the substrate (1),
- in which a barrier layer (3) is then produced, which is provided as a diffusion and/or etching barrier, leaves at least the first doped region (2a) uncovered and covers a second doped region (2b) of a second conductivity type,
- in which an undoped silicon layer (4) is deposited over the whole area,
- in which a doped zone, which overlaps the region for the subsequent contact hole, is selectively produced in the silicon layer (4) by implantation or additionally by outdiffusion from the first doped region (2a),
- in which a heat treatment is performed in order to distribute and activate the dopant in the doped zone of the silicon layer (4), outdiffusion from the second doped region into the undoped silicon layer (4) being prevented at the locations at which the barrier layer (3) covers the second doped region (2b),
- in which undoped parts of the silicon layer (4) are removed selectively with respect to the doped zone,
- in which an insulation layer (6) is produced over the whole area,
- in which the contact hole (7a) is opened in the insulation layer (6) by means of anisotropic etching selectively with respect to the doped zone (4c) of the silicon layer.

2. Method according to Claim 1, in which the substrate (10) is composed of monocrystalline silicon.

3. Method according to Claim 1 or 2, in which the silicon layer (4) is fabricated from polysilicon.

4. Method according to one of Claims 1 to 3, in which the undoped parts of the silicon layer (4) are removed by wet-chemical etching.

5. Method according to one of Claims 1 to 4, in which the barrier layer (3) is fabricated from silicon nitride.

6. Method according to one of Claims 1 to 5, in which the uncovered parts of the barrier layer (3) are removed prior to the application of the insulation layer (6).

7. Method according to one of Claims 1 to 6, in which the doped zone (4c) of the silicon layer (4) is p-doped, and in which the undoped parts of the silicon layer (4) are removed by wet-chemical etching using potassium hydroxide solution.

8. Method according to Claim 7, in which a boron concentration of between 10¹⁹ cm⁻³ and 10²¹ cm⁻³ is set in the doped zone (4c) of the silicon layer (4).

9. Method according to one of Claims 1 to 8,
- in which the doped region (2a) in the substrate (10) is a source-drain zone of a MOS transistor,
- in which the insulation regions comprise insulating sidewall coverings (13) and insulating covering layers (12) of the gate electrode (1) of the
MOS transistor.

10. Method according to Claim 9,
- in which a further contact hole (7b) to the gate electrode (10) is opened at the same time that the contact hole (7a, 7c) to the doped region (2a) is opened.

11. Method according to one of Claims 9 to 10, in which the MOS transistor (1, 2) is a selection transistor of a memory cell comprising a storage capacitor, one electrode of the storage capacitor being connected to a further doped zone of the MOS transistor via a doped polysilicon structure.

## Revendications

1. Procédé de fabrication d'un trou de contact sur une première région dopée d'un premier type de conductibilité avec une tranche de semi-conducteur présentant des régions dopées du premier et d'un second type de conductibilité,
- dans lequel, tout d'abord, la première région dopée (2a) dans le substrat (10) est réalisée de telle sorte qu'elle soit au moins limitée à la surface du substrat (1) par des zones isolantes (12, 13),
- dans lequel une couche-barrière (3) prévue comme barrière de diffusion resp. de gravure est ensuite créée, qui laisse libre au moins la première région dopée (2a) et qui recouvre une seconde région dopée (2b) d'un second type de conductibilité,
- dans lequel une couche de silicium (4) non dopée est déposée sur toute la surface,
- dans lequel une zone dopée est créée sélectivement dans la couche de silicium (4) par implantation ou en plus par diffusion extérieure de la première région dopée (2a) qui recouvre la région du futur trou de contact,
- dans lequel un recuit est effectué pour répartir et activer l'agent dopant dans la zone dopée de la couche de silicium (4), une diffusion de la seconde région dopée dans la couche de silicium non dopée (4) étant empêchée aux endroits auxquels la couche-barrière (3) recouvre la seconde région dopée (2b),
- dans lequel des parties non dopées de la couche de silicium (4) sont éliminées sélectivement jusqu'à la zone dopée,
- dans lequel une couche isolante (6) est produite sur toute la surface,
- dans lequel le trou de contact (7a) est ouvert sélectivement par gravure anisotrope jusqu'à la zone dopée (4c) de la couche de silicium dans la couche isolante (6).

2. Procédé selon la revendication 1, dans lequel le substrat (10) est constitué de silicium monocristallin.

3. Procédé selon la revendication 1 ou 2, dans lequel la couche de silicium (4) est fabriquée en polysilicium.

4. Procédé selon l'une des revendications 1 à 3, dans lequel les parties non dopées de la couche de silicium (4) sont éliminées par gravure chimique humide.

5. Procédé selon l'une des revendications 1 à 4, dans lequel la couche-barrière (3) est fabriquée à partir de nitrure de silicium.

6. Procédé selon l'une des revendications 1 à 5, dans lequel les parties découvertes de la couche-barrière (3) sont éliminées avant le dépôt de la couche isolante (6).

7. Procédé selon l'une des revendications 1 à 8, dans lequel la zone dopée (4c) de la couche de silicium (4) est dopée p et dans lequel les parties non dopées de la couche de silicium (4) sont éliminées par gravure chimique humide avec une solution d'hydroxyde de potassium.

8. Procédé selon la revendication 7, dans lequel une concentration de bore est ajustée entre 10¹⁹ cm⁻³ et 10²¹ cm⁻³ dans la zone dopée (4c) de la couche de silicium (4).

9. Procédé selon l'une des revendications 1 à 8,
- dans lequel la région dopée (2a) dans le substrat (10) est une zone-source-drain d'un transistor MOS,
- dans lequel les zones isolantes comprennent des recouvrements des flancs (13) isolants et des couches de couverture (12) isolantes de l'électrode de grille (1) du transistor MOS.

10. Procédé selon la revendication 9,
- dans lequel simultanément avec l'ouverture du trou de contact (7a, 7c) sur la région dopée (2a), un trou de contact supplémentaire (7b) est ouvert sur l'électrode de grille (10).

11. Procédé selon l'une des revendications 9 à 10, dans lequel le transistor MOS (1, 2) est un transistor de sélection d'une cellule de mémoire, laquelle comprend un condensateur de mémoire, une électrode du condensateur de mémoire étant reliée à une zone dopée supplémentaire du transistor MOS via une structure en polysilicium dopée.
